(19) Europäisches Patentamt
European Patent Office
Office européen des brevets

(11) EP 4 811 428 A1

(12) # EUROPEAN PATENT APPLICATION
published in accordance with Art. 153(4) EPC

(43) Date of publication:
**23.09.2026 Bulletin 2026/39**

(21) Application number: **24891074.7**

(22) Date of filing: **12.09.2024**

(51) International Patent Classification (IPC):
***H01L 23/36*** *(2006.01)* ***C08J 5/18*** *(2006.01)*
***C08L 83/05*** *(2006.01)* ***C08L 83/07*** *(2006.01)*
***H01L 23/373*** *(2006.01)* ***H05K 7/20*** *(2006.01)*

(52) Cooperative Patent Classification (CPC):
**C08J 5/18; C08L 83/04; H05K 7/20; H10W 40/10; H10W 40/25**

(86) International application number:
**PCT/JP2024/032707**

(87) International publication number:
**WO 2025/105032 (22.05.2025 Gazette 2025/21)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **17.11.2023 JP 2023195755**

(71) Applicant: **SHIN-ETSU CHEMICAL CO., LTD.**
**Tokyo 100-0005 (JP)**

(72) Inventor: **TSUKADA, Junichi**
**Annaka-shi, Gunma 379-0224 (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

(54) **INSULATING HEAT TRANSFER SHEET**

(57) The present invention is an insulating and thermally conductive sheet, being a cured product of a thermally conductive silicone resin composition including the following components (A) to (D), in which a peak intensity ratio (degree of orientation) in the thickness direction as detected by X-ray diffraction of the insulating and thermally conductive sheet is [2θ = 41 to 43°]/[2θ = 25 to 27°] = 1 or more: (A) an organopolysiloxane having two or more alkenyl groups bonded to a silicon atom per molecule, (B) an organohydrogenpolysiloxane containing components (B1) and (B2), and having two or more hydrosilyl groups per molecule, (C) a hydrosilylation catalyst, and (D) a flat boron nitride having an average particle size of 30 to 100 μm as measured by laser diffraction and having an aspect ratio of 20 to 100. This provides an insulating and thermally conductive sheet that has excellent thermal conductivity in the thickness direction and high sheet strength.

[FIG. 1]

1

EP 4 811 428 A1

## Description

TECHNICAL FIELD

The present invention relates to an insulating and thermally conductive sheet.

BACKGROUND ART

In recent years, advances in the performance of electronic devices have driven further increases in the integration density and packaging sophistication of semiconductor devices.

The electrification of automobiles in particular has progressed significantly, with an increasing number of electronic components installed, driving demand for heat dissipation materials. Heat dissipation materials are available in sheet and grease types, with sheet types preferred due to their ease of installation. In addition, with autonomous driving becoming a trend, there is a demand for further improved thermal conductivity in these heat dissipation materials. Commonly, achieving high thermal conductivity requires a high filling rate of the filler dispersed within the polymer, which tends to result in a higher specific gravity, but this poses a problem when it comes to reducing weight to improve the fuel efficiency of gasoline-powered vehicles and the electric power efficiency of electric vehicles.

For example, Patent Document 1 proposes a method for producing a thermally conductive resin sheet, comprising at least a curing step of extruding a thermally conductive composition containing a polymer, an anisotropic filler, and a filler through an extruder, and curing the extruded product to obtain a cured product, and a cutting step of cutting the cured product in a direction perpendicular to the extrusion direction into a given thickness with an ultrasonic cutter.

In addition, for example, Patent Document 2 proposes a method for producing a thermally conductive sheet, comprising applying a magnetic field to a thermally conductive composition containing a polymer, an anisotropic filler, and a filler to orient the anisotropic thermally conductive filler, forming a block-like molded body, and slicing it to the desired sheet thickness.

Further, Patent Documents 3 and 4 each propose a method for producing a thermally conductive sheet, comprising filling a resin with anisotropic fillers and orienting the fillers in an in-plane direction to from primary sheets, then laminating the sheets to obtain a molded body, and slicing the molded body in a direction perpendicular to the orientation direction. This method makes it relatively easy to obtain large-area thermally conductive sheets, and is a production method that is highly suitable for mass production.

However, when the primary sheets are laminated to create a molded body, interlayer adhesion between the primary sheets poses a major challenge. That is, when the adhesive strength of the primary sheets is insufficient, the strength of the thermally conductive sheet obtained by slicing them will be significantly reduced, making it difficult to withstand use as an insulating and thermally conductive sheet. In addition, when adhesive is used between the layers of the primary sheets, the expansion coefficients of the respective materials will affect the sheet, causing embrittlement due to temperature changes, raising major concerns about long-term reliability.

CITATION LIST

PATENT LITERATURE

Patent Document 1: JP 2012-023335 A
Patent Document 2: JP 2019-186555 A
Patent Document 3: JP 2017-126614 A
Patent Document 4: WO 2021/090929 A1


SUMMARY OF INVENTION

TECHNICAL PROBLEM

The present invention was developed in consideration of the above circumstances, and an object of thereof is to provide an insulating and thermally conductive sheet that has excellent thermal conductivity in the thickness direction while having high sheet strength.

SOLUTION TO PROBLEM

In order to solve the above problems, the present invention provides an insulating and thermally conductive sheet, being a cured product of a thermally conductive silicone resin composition comprising the following components (A) to (D), wherein a peak intensity ratio (degree of orientation) in the thickness direction as detected by X-ray diffraction of the insulating and thermally conductive sheet is [2θ = 41 to 43°]/[2θ = 25 to 27°] = 1 or more:

(A) an organopolysiloxane having two or more alkenyl groups bonded to a silicon atom per molecule: 100 parts by mass;
(B) an organohydrogenpolysiloxane containing the following components (B1) and (B2), and having two or more hydrosilyl groups per molecule: an amount of the component (B) added is such that a number of moles of hydrosilyl groups derived from the component (B) is 1.3 to 2.0 based on 1 mole of alkenyl groups derived from the component (A), and a ratio of a number of moles of hydrosilyl groups in the component (B1) to the component (B2) is 1:1 to 1:5 :

(B1) an organohydrogenpolysiloxane represented by the following formula (1):

$$CH_3-\overset{\overset{\displaystyle CH_3}{|}}{\underset{\underset{\displaystyle CH_3}{|}}{Si}}-O-\left[\overset{\overset{\displaystyle H}{|}}{\underset{\underset{\displaystyle CH_3}{|}}{Si}}-O\right]_m\left[\overset{\overset{\displaystyle CH_3}{|}}{\underset{\underset{\displaystyle CH_3}{|}}{Si}}-O\right]_n\overset{\overset{\displaystyle CH_3}{|}}{\underset{\underset{\displaystyle CH_3}{|}}{Si}}-CH_3 \quad (1)$$

wherein "m" is an integer of 4 to 20, "n" is an integer of 10 to 40, and the sequence of bonding of siloxane units enclosed by "m" and "n" can be structured in either a block or random fashion,
(B2) an organohydrogenpolysiloxane having hydrosilyl groups only at both ends, represented by the following formula (2):

$$H-\overset{\overset{\displaystyle CH_3}{|}}{\underset{\underset{\displaystyle CH_3}{|}}{Si}}-O-\left[\overset{\overset{\displaystyle CH_3}{|}}{\underset{\underset{\displaystyle CH_3}{|}}{Si}}-O\right]_p\overset{\overset{\displaystyle CH_3}{|}}{\underset{\underset{\displaystyle CH_3}{|}}{Si}}-H \quad (2)$$

wherein "p" is an integer of 40 to 200;

(C) a hydrosilylation catalyst: an amount that provides 100 to 3,000 ppm of platinum group metal elements on a mass basis based on the component (A); and
(D) a flat boron nitride having an average particle size of 30 to 100 μm as measured by laser diffraction and having an aspect ratio of 20 to 100: 200 to 800 parts by mass.

The insulating and thermally conductive sheet of the present invention has excellent thermal conductivity in the thickness direction while maintaining high sheet strength.
The insulating and thermally conductive sheet of the present invention preferably has a thermal conductivity in the thickness direction of 17 to 30 W/m·K.
Such an insulating and thermally conductive sheet has excellent thermal conductivity in the thickness direction.
Further, the insulating and thermally conductive sheet of the present invention preferably has a Shore A hardness of 5 to 60.
This insulating and thermally conductive sheet may not deform or lose its orientation, and the contact thermal resistance between the heating and cooling elements of the insulating and thermally conductive sheet does not increase.
The insulating and thermally conductive sheet of the present invention preferably has a breakdown voltage of 5 kV/mm or more.
Such an insulating and thermally conductive sheet has excellent insulating properties.
Further, the insulating and thermally conductive sheet of the present invention preferably has a specific gravity of 1.2 to 2.0.
Such an insulating and thermally conductive sheet is preferable for reducing the weight of heat dissipation materials.

## ADVANTAGEOUS EFFECTS OF INVENTION

As described above, the insulating and thermally conductive sheet of the present invention has excellent thermal conductivity in the thickness direction while maintaining high sheet strength. The insulating and thermally conductive sheet also has excellent mechanical strength, eliminating the risk of damage of the sheet during use.

## BRIEF DESCRIPTION OF DRAWINGS

[FIG. 1] is an example of a mold used in the filling step;
[FIG. 2] is a cross-sectional structure of the mold in FIG. 1; and
[FIG. 3] is an example of a mold used in the molding step.

## DESCRIPTION OF EMBODIMENTS

As described above, there has been a need for the development of an insulating and thermally conductive sheet that possesses both excellent thermal conductivity in the thickness direction and high sheet strength.

As a result of extensive research into the above-described issues, the inventor has found that highly orienting a flat boron nitride and controlling the crosslinking structure of the silicone resin can provide an insulating and thermally conductive sheet that possesses both excellent thermal conductivity in the thickness direction and high sheet strength, leading to the completion of this invention.

That is, the present invention is an insulating and thermally conductive sheet, being a cured product of a thermally conductive silicone resin composition comprising the following components (A) to (D), wherein a peak intensity ratio (degree of orientation) in the thickness direction as detected by X-ray diffraction of the insulating and thermally conductive sheet is [$2\theta$ = 41 to 43°]/[$2\theta$ = 25 to 27°] = 1 or more:

(A) an organopolysiloxane having two or more alkenyl groups bonded to a silicon atom per molecule: 100 parts by mass;

(B) an organohydrogenpolysiloxane containing the following components (B1) and (B2), and having two or more hydrosilyl groups per molecule: an amount of the component (B) added is such that a number of moles of hydrosilyl groups derived from the component (B) is 1.3 to 2.0 based on 1 mole of alkenyl groups derived from the component (A), and a ratio of a number of moles of hydrosilyl groups in the component (B1) to the component (B2) is 1:1 to 1:5 :

(B1) an organohydrogenpolysiloxane represented by the following formula (1):

$$CH_3-\underset{CH_3}{\overset{CH_3}{Si}}-O-\left[\underset{CH_3}{\overset{H}{Si}}-O\right]_m-\left[\underset{CH_3}{\overset{CH_3}{Si}}-O\right]_n-\underset{CH_3}{\overset{CH_3}{Si}}-CH_3 \quad (1)$$

wherein "m" is an integer of 4 to 20, "n" is an integer of 10 to 40, and the sequence of bonding of siloxane units enclosed by "m" and "n" can be structured in either a block or random fashion,

(B2) an organohydrogenpolysiloxane having hydrosilyl groups only at both ends, represented by the following formula (2):

$$H-\underset{CH_3}{\overset{CH_3}{Si}}-O-\left[\underset{CH_3}{\overset{CH_3}{Si}}-O\right]_p-\underset{CH_3}{\overset{CH_3}{Si}}-H \quad (2)$$

wherein "p" is an integer of 40 to 200;

(C) a hydrosilylation catalyst: an amount that provides 100 to 3,000 ppm of platinum group metal elements on a mass basis based on the component (A); and

(D) a flat boron nitride having an average particle size of 30 to 100 μm as measured by laser diffraction and having an aspect ratio of 20 to 100: 200 to 800 parts by mass.

The present invention is described in detail below, but is not limited thereto.

[Insulating and thermally conductive sheet]

The insulating and thermally conductive sheet of the present invention is obtained by molding a thermally conductive silicone resin composition including the flat boron nitride (D) in addition to the above-described components (A) to (C) using the method described below. This is described in detail below.

[Thermally conductive silicone resin composition]

The thermally conductive silicone resin composition of the present invention is an addition-curable organopolysiloxane composition including the following components (A) to (C) and the (D) flat boron nitride,

(A) an organopolysiloxane having two or more alkenyl groups per molecule,
(B) an organohydrogenpolysiloxane, and
(C) a hydrosilylation catalyst.

[(A) Organopolysiloxane having two or more alkenyl groups per molecule]

The component (A) is an organopolysiloxane having two or more alkenyl groups bonded to a silicon atom per molecule, and serves as the base component of the thermally conductive silicone resin composition of the present invention. The main chain typically consists essentially of repeating diorganosiloxane units. The molecular structure may include a branched structure or may include a cyclic structure, and linear diorganopolysiloxanes are preferable from the viewpoint of physical properties such as the mechanical strength of the cured product.

Examples of the alkenyl group include a vinyl group, an allyl group, a propenyl group, an isopropenyl group, a butenyl group, a hexenyl group, and a cyclohexenyl group, which typically have about 2 to 8 carbon atoms, and among these, lower alkenyl groups having 2 to 4 carbon atoms, such as a vinyl group and an allyl group, are preferable, with a vinyl group being particularly preferable. Preferably, two or more alkenyl groups are present in the molecule, and in order to improve the flexibility of the resulting cured product, it is more preferable that the alkenyl groups are present only in the form of being bonded to silicon atoms at the molecular chain terminals.

Examples of the functional groups other than the alkenyl group include monovalent hydrocarbon groups, and among them, those having 1 to 10 carbon atoms, and particularly those having 1 to 6 carbon atoms. Examples thereof include: alkyl groups such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, and a decyl group; cycloalkyl groups such as a cyclopentyl group, a cyclohexyl group, and a cycloheptyl group; aryl groups such as a phenyl group, a tolyl group, a xylyl group, and a naphthyl group; and aralkyl groups such as a benzyl group, a phenylethyl group, a phenylpropyl group, and a methylbenzyl group. Preferable are alkyl groups having 1 to 3 carbon atoms, such as a methyl group, an ethyl group, and a propyl group, and a phenyl group. In addition, functional groups other than alkenyl groups bonded to silicon atoms do not necessarily have to be all the same.

The kinematic viscosity of this organopolysiloxane at 23°C is preferably 10 to 100,000 $mm^2/s$, and more preferably 100 to 100,000 $mm^2/s$. When the kinematic viscosity is 10 $mm^2/s$ or more, the resulting resin composition has favorable storage stability, and when 100,000 $mm^2/s$ or less, the resulting resin composition has favorable extensibility.

In the present specification, the kinematic viscosity is the value measured at 25°C using a Cannon-Fenske viscometer as described in JIS Z 8803:2011.

One kind of the organopolysiloxane as the component (A) may be used singly, or a combination of two or more kinds thereof with different kinematic viscosities may be used.

[(B) Organohydrogenpolysiloxane]

The component (B) is an organohydrogenpolysiloxane and is a mixture of a component (B1) of the following formula (1) and a component (B2) of the following formula (2):

(B1)

$$CH_3-\underset{CH_3}{\overset{CH_3}{Si}}-O-\left[\underset{CH_3}{\overset{H}{Si}}-O\right]_m-\left[\underset{CH_3}{\overset{CH_3}{Si}}-O\right]_n-\underset{CH_3}{\overset{CH_3}{Si}}-CH_3 \quad (1)$$

wherein "m" is an integer of 4 to 20, "n" is an integer of 10 to 40, and the sequence of bonding of the siloxane units enclosed by "m" and "n" can be structured in either a block or random fashion,

(B2)

$$H-\underset{CH_3}{\overset{CH_3}{Si}}-O-\left[\underset{CH_3}{\overset{CH_3}{Si}}-O\right]_p-\underset{CH_3}{\overset{CH_3}{Si}}-H \quad (2)$$

wherein "p" is an integer of 40 to 200.

The organohydrogenpolysiloxane as the component (B1) is an organohydrogenpolysiloxane having 4 to 20 hydrogen atoms directly bonded to silicon atoms (hydrosilyl groups) per molecule, and functions as a crosslinking agent for the component (A). That is, the hydrosilyl groups in the component (B1) adds to the alkenyl groups in the component (A), by a hydrosilylation reaction promoted by the hydrosilylation catalyst as the component (C) described below, to give a three-dimensional network structure.

Meanwhile, when the organohydrogenpolysiloxane having hydrosilyl groups at both ends in the component (B2) adds to the alkenyl group in the component (A), it merely extends the molecular chain and does not interfere with the free movement of the molecules.

The molar ratio of hydrosilyl groups in the components (B1) to (B2) is 1:1 to 1:5, with 1:1 to 1:4 being preferable. When the molar ratio of hydrosilyl groups in the components (B1) to (B2) is larger than 1:5, the proportion of the three-dimensional network structure in the composition decreases, failing to provide sufficient sheet strength. Meanwhile, a ratio less than 1:1 is undesirable, because the sheet becomes rigid and loses flexibility.

The amount of the component (B) added is such that hydrosilyl groups derived from the component (B) account for 1.3 to 2.0 moles based on 1 mole of alkenyl groups derived from the component (A) (that is, an amount such that the number of moles of hydrosilyl groups is 1.3 to 2.0 times the number of moles of alkenyl groups derived from the component (A)). When the amount of hydrosilyl groups derived from the component (B) is less than 1.3 moles based on 1 mole of alkenyl groups derived from the component (A), the proportion of crosslinked structures decreases, resulting in insufficient curing. In addition, at more than 2.0 moles, the amount of hydrosilyl groups is excessive, which may cause foaming on the sheet due to dehydrogenation.

[(C) Hydrosilylation catalyst]

The hydrosilylation catalyst (C) is a catalyst that promotes the addition reaction between the alkenyl group derived from the component (A) and the hydrosilyl group derived from the component (B), and examples thereof include catalysts well known for use in hydrosilylation reactions. Specific examples thereof include: platinum-group metal elements such as platinum (including platinum black), rhodium, and palladium; platinum chlorides, chloroplatinic acids, and chloroplatinic acid salts such as $H_2PtCl_4 \cdot nH_2O$, $H_2PtCl_6 \cdot nH_2O$, $NaHPtCl_6 \cdot nH_2O$, $KHPtCl_6 \cdot nH_2O$, $Na_2PtCl_6 \cdot nH_2O$, $K_2PtCl_4 \cdot nH_2O$, $PtCl_4 \cdot nH_2O$, $PtCl_2$, and $Na_2HPtCl_4 \cdot nH_2O$ (wherein "n" is an integer of 0 to 6, preferably 0 or 6); alcohol-modified chloroplatinic acid (see US 3,220,972 A); complexes of chloroplatinic acid with olefins (see US 3,159,601 A, US 3,159,662 A, and US 3,775,452 A); those obtained by supporting platinum-group metals such as platinum black and palladium on carriers such as alumina, silica, and carbon; rhodium-olefin complexes; chlorotris(triphenylphosphine) rhodium (Wilkinson's catalyst); and complexes of platinum chloride, chloroplatinic acid, or chloroplatinic acid salt with vinyl group-containing siloxanes, particularly vinyl group-containing cyclic siloxanes.

The content of the component (C), calculated as the mass of platinum group metal element based on the component (A), is 100 to 3,000 ppm, preferably 100 to 2,000 ppm. When the content of the component (C) is less than 100 ppm, sufficient catalytic activity is not obtained, and more than 3,000 ppm is excessive as a catalyst and is not preferable from the viewpoint of cost.

[(D) Flat boron nitride]

The flat boron nitride as the component (D) is a particle that is oriented in the thickness direction of the sheet and promotes thermal conduction. Hexagonal boron nitride is particularly preferable from the viewpoint of thermal conduction and electrical insulation in the thickness direction of the heat dissipation sheet. Further, the shape is flat, and a scale-like shape, a plate-like shape, or a flake-like shape are particularly preferable.
The aspect ratio of the flat boron nitride is 20 to 100, preferably 50 to 100. When the aspect ratio is less than 20, the orientation important for increasing thermal conductivity cannot be ensured, and more than 100 is not preferable, because the boron nitride itself becomes susceptible to damage due to stirring shear or pumping during filling into silicone resin.
The aspect ratio is a value obtained by dividing the major axis of a particle by its thickness, that is, major axis/thickness. When a particle is spherical, the aspect ratio is 1, and the aspect ratio increases as the particle becomes flatter.
The aspect ratio can be obtained by measuring the major axis and thickness of a particle at a magnification of 1,500 x using a scanning electron microscope and calculating the ratio of a major axis to thickness.
The average particle size of the flat boron nitride is 30 to 100 μm, preferably 40 to 90 μm, and more preferably 50 to 80 μm.
In order to efficiently form thermal conduction paths through the thickness of an insulating and thermally conductive sheet, it is necessary to reduce the number of contact points between fillers. When the average particle size of the flat boron nitride is less than 30 μm, the number of contact points between the flat boron nitride particles increases, resulting in insufficient thermal conductivity, and when more than 100 μm, the flexibility of the insulating and thermally conductive sheet is impaired, making cracks more likely to occur. The flat boron nitride with a single average particle size may be used, or a plurality of types with different average particle sizes may be mixed.
The average particle size is the median diameter (the particle size at which, when a powder is divided into two at a certain particle size, the particles larger than and smaller than that particle size are equal in quantity; commonly known as D50) measured by the laser diffraction method using a laser diffraction/scattering particle size distribution analyzer.
The content of the flat boron nitride is 200 to 800 parts by mass, preferably 300 to 600 parts by mass, based on 100 parts by mass of the component (A). When the content of the flat boron nitride is less than 200 parts by mass, the thermal conductivity in the thickness direction of the insulating and thermally conductive sheet is insufficient, and when more than 800 parts by mass, the insulating and thermally conductive sheet becomes brittle and the strength of the sheet becomes insufficient.
In addition, in addition to the flat boron nitride, insulating inorganic particles such as alumina, magnesia, aluminum hydroxide, aluminum nitride, silicon nitride, and silica can be used in combination. Using other insulating inorganic particles in combination makes it possible to adjust the viscosity of the composition, thus providing a preferable aspect in terms of processability.

[(E) Diluting solvent]

The thermally conductive silicone resin composition can be blended with a diluting solvent to reduce the viscosity of the composition during kneading. Solvents that can be used include: nonpolar solvents such as normal hexane, cyclohexane, benzene, toluene, and xylene; alcohols such as methanol, ethanol, and isopropanol; ketones such as acetone and methyl ethyl ketone; and ethers such as diethyl ether and tetrahydrofuran. A solvent remaining in the composition causes foaming during molding or the thermal conductivity of the molded product to be reduced, and thus solvents with a boiling point of 150°C or less are preferable, because of easy removal in the heating step prior to the molding step.

[Other components]

The thermally conductive silicone resin composition can be further blended with other components, such as thixotropic agents, dispersions, curing agents, cure accelerators, retarders, tackifiers, plasticizers, flame retardants, antioxidants, stabilizers, and colorants, as necessary.
In addition, the thermally conductive silicone resin composition may be blended with a filler other than the component (D). Specific examples thereof include silica and titanium oxide. The amount of the filler blended is not particularly limited, and is preferably 0 to 60 parts by mass, and more preferably 0 to 40 parts by mass, based on 100 parts by mass of the component (A).

[Method for producing thermally conductive silicone resin composition]

The thermally conductive silicone resin composition of the present invention can be produced by mixing the

above-described thermosetting silicone resin, the above-described flat boron nitride, and, as necessary, the above-described other components using a mixer or the like.

[Method for producing insulating and thermally conductive sheet]

The method for producing the insulating and thermally conductive sheet of the present invention includes the steps of molding and curing the above-described thermally conductive silicone resin composition, and examples of such methods include the following.

One example of a method for producing the insulating and thermally conductive sheet of the present invention includes a production method involving the following steps:

a filling step of filling a thermally conductive silicone resin composition into a mold;
a vibration step of vibrating the mold ultrasonically to degas and align a flat boron nitride;
a heating step of heating the thermally conductive silicone resin composition to obtain a string-like semi-cured silicone composition;
a molding of molding the string-like semi-cured silicone composition by aligning longitudinally, heating, and pressurizing to obtain a thermally conductive silicone molded body; and
a slicing step of slicing the thermally conductive silicone molded body to obtain an insulating and thermally conductive sheet with the desired thickness.

The flat boron nitride is highly oriented by the above method, thereby making it possible to obtain a flexible, insulating and thermally conductive sheet with excellent thermal conductivity in the thickness direction.

The following describes each of the above steps in detail.

<u>Filling step</u>

(Mold used in filling step)

The mold used in the filling step has a width of 5.0 mm or less, a depth of at least the width plus 1.0 mm, and a length of at least 10.0 mm, and the bottom shape is not particularly limited, and includes at least one groove, such as a wedge-like, semicircular-like, wavy-like, and flat shape.

(Filling method)

During the filling step, the mold groove may be filled with a specified amount of a thermally conductive silicone resin composition, or a large amount of a thermally conductive silicone resin composition may be filled and then the excess may be scraped off with a squeegee or the like.

Adding a solvent to the thermally conductive silicone resin composition is preferable, because of reducing the viscosity of the composition and improving filling properties. In addition, during degassing and sedimentation of the flat boron nitride in the subsequent vibration step, the major axis of the flat boron nitride is likely to align with the major axis of the string-like semi-cured silicone composition.

<u>Vibration step</u>

The vibration step is performed by ultrasonically vibrating the mold for degassing and aligning the flat boron nitride. To obtain the string-like semi-cured silicone composition in the subsequent heating step, the mold is ultrasonically vibrated to perform degassing and to precipitate and orient the flat boron nitride, allowing the flat boron nitride to be aligned in the major axis along the major axis of the string-like semi-cured silicone composition.

<u>Heating step</u>

The heating step is a step of heating the thermally conductive silicone resin composition to obtain the string-like semi-cured silicone composition. When the thermally conductive silicone resin composition includes a solvent, a step of volatilizing the solvent by heating is also included. The heating temperature in the heating step is preferably 40 to 100°C, more preferably 60 to 80°C. The heating time is preferably 1 to 60 minutes, more preferably 5 to 30 minutes.

<u>Molding step</u>

(Mold used in molding step)

The mold is a concave mold with inner dimensions of 10.0 mm or more in width, 10.0 mm or more in length, and 10.0 mm or more in depth, and has a lower mold with a flat bottom and an upper mold with the width and length being 0.01 to 0.2 mm shorter than the inner dimensions of the lower mold. The height of the upper mold is not particularly limited, and a height that allows the upper mold to be pressurized is required.

(Filling method)

The string-like semi-cured silicone composition obtained in the heating step is filled into the lower mold of the mold as follows:

(i) the composition is aligned in the mold such that the longitudinal direction is parallel to the X-axis, and then stacked along the Z-axis and filled; and
(ii) the composition is aligned in the mold such that the longitudinal direction is parallel to the Y-axis, and then stacked along the Z-axis and filled.

This allows a thermally conductive silicone molded body with oriented flat boron nitride to be more preferably and efficiently obtained.
The number of times stacking in the Z-axis direction is preferably two or more, and more preferably 5 to 3,000 times.

(Molding method)

The molding step is a step of pressurizing the lower mold of the mold in the Z-axis direction with the upper mold of the mold, and heating to completely cure the string-like semi-cured silicone composition, thereby obtaining a thermally conductive silicone molded body.
Preferably, the pressurizing method is to gradually increase pressure from atmospheric pressure until the desired pressure is reached.
The pressure for pressurizing the mold is selected appropriately depending on the desired shape and hardness of the thermally conductive silicone molded body, and is preferably 0.1 to 20.0 MPa, and more preferably 0.5 to 5.0 MPa.
The temperature for pressurizing the mold is preferably -10 to 40°C, more preferably 0 to 30°C.
The curing temperature of the string-like semi-cured silicone composition is preferably 50 to 200°C, more preferably 100 to 150°C. In addition, the curing time is preferably 1 minute to 24 hours, more preferably 5 minutes to 1 hour.

<u>Slicing step</u>

The slicing step is a step of slicing the thermally conductive silicone molded body obtained in the molding step to obtain an insulating and thermally conductive sheet with the desired thickness. Specifically, the slicing step involves the following steps (i) and (ii).

(i) The molded body filled in the mold by aligning such that the longitudinal direction is parallel to the X-axis and then stacking along the Z-axis is sliced parallel to the Y-Z plane to the desired thickness of the mold body, and
(ii) the molded body filled in the mold by aligning such that the longitudinal direction is parallel to the Y-axis and then stacking along the Z-axis is sliced parallel to the X-Z plane to the desired thickness of the molded body, thereby slicing the thermally conductive silicone molded body to the desired thickness, which can provide an insulating and thermally conductive sheet in which the longitudinal direction of the flat boron nitride is oriented in the thickness direction of the sheet.

[Orientation degree]

The orientation degree of the insulating and thermally conductive sheet of the present invention is 1 or more. An orientation degree of less than 1 is not preferable because the thermal conduction path through the thickness of the flat boron nitride is deteriorated.

[Thermal conductivity]

The thermal conductivity of the insulating and thermally conductive sheet of the present invention through the

thickness is preferably 17 to 30 W/m·K. A thermal conductivity through the thickness within the range of 17 to 30 W/m·K allows smooth heat transfer between heating and cooling elements through the insulating and thermally conductive sheet.

[Hardness]

From the viewpoint of sheet strength and heat dissipation, the hardness of the insulating and thermally conductive sheet of the present invention is preferably a Shore A hardness of 5 to 60, more preferably 10 to 50. A Shore A hardness in the range of 5 to 60 prevents deformation and loss of orientation of the insulating and thermally conductive sheet, and prevents increased contact thermal resistance between the insulating and thermally conductive sheet and heating or cooling elements.

[Breakdown voltage]

The breakdown voltage of the insulating and thermally conductive sheet of the present invention is preferably 5 kV/mm or more. A breakdown voltage of 5 kV/mm or more provides excellent insulation.

[Specific gravity]

The specific gravity of the insulating and thermally conductive sheet of the present invention is preferably 1.2 to 2.0. A specific gravity in the range of 1.2 to 2.0 is preferable for reducing the weight of the heat dissipation materials.

EXAMPLE

The present invention will be explained in detail below using examples and comparative examples, but the present invention is not limited to these.
The kinematic viscosity is the value measured at 25°C using a Cannon-Fenske viscometer as specified in JIS Z 8803:2011, the aspect ratio is determined by SEM measurement, and the average particle size is the cumulative average particle size (median diameter) on a volume basis measured using a Microtrac MT3300EXII particle size analyzer manufactured by MicrotracBEL Corp.

(Preparation of thermally conductive silicone resin composition)

The components (A) to (C) used in the following examples are listed below.

Component (A): an alkenyl group-containing organopolysiloxane represented by the following formula (3)

$$CH_2{=}CH-\underset{CH_3}{\overset{CH_3}{Si}}-O-\left[\underset{CH_3}{\overset{CH_3}{Si}}-O\right]_q-\underset{CH_3}{\overset{CH_3}{Si}}-CH{=}CH_2 \quad (3)$$

(A1) In the above formula, q is the number that results in a kinematic viscosity of 600 $mm^2/s$ at 25°C.
(A2) In the above formula, q is the number that results in a kinematic viscosity of 100,000 $mm^2/s$ at 25°C.

Component (B): organohydrogenpolysiloxanes represented by the following formulae (4) to (9)
Component (B1-a)

$$CH_3-\underset{CH_3}{\overset{CH_3}{Si}}-O-\left[\underset{CH_3}{\overset{H}{Si}}-O\right]_{16}\left[\underset{CH_3}{\overset{CH_3}{Si}}-O\right]_{28}\underset{CH_3}{\overset{CH_3}{Si}}-CH_3 \quad (4)$$

(The sequence of the siloxane units in parentheses is structured in a random fashion.)
Component (B1-b)

$$CH_3-\underset{CH_3}{\overset{CH_3}{Si}}-O-\left[\underset{CH_3}{\overset{H}{Si}}-O\right]_{20}\left[\underset{CH_3}{\overset{CH_3}{Si}}-O\right]_{18}-\underset{CH_3}{\overset{CH_3}{Si}}-CH_3 \quad (5)$$

(The sequence of the siloxane units in parentheses is structured in a random fashion.)
Component (B1-c)

$$CH_3-\underset{CH_3}{\overset{CH_3}{Si}}-O-\left[\underset{CH_3}{\overset{H}{Si}}-O\right]_{2}\left[\underset{CH_3}{\overset{CH_3}{Si}}-O\right]_{27}-\underset{CH_3}{\overset{CH_3}{Si}}-CH_3 \quad (6)$$

(The sequence of the siloxane units in parentheses is structured in a random fashion.)
Component (B2-d)

$$H-\underset{CH_3}{\overset{CH_3}{Si}}-O-\left[\underset{CH_3}{\overset{CH_3}{Si}}-O\right]_{100}-\underset{CH_3}{\overset{CH_3}{Si}}-H \quad (7)$$

Component (B2-e)

$$H-\underset{CH_3}{\overset{CH_3}{Si}}-O-\left[\underset{CH_3}{\overset{CH_3}{Si}}-O\right]_{40}-\underset{CH_3}{\overset{CH_3}{Si}}-H \quad (8)$$

Component (B2-f)

$$H-\underset{CH_3}{\overset{CH_3}{Si}}-O-\left[\underset{CH_3}{\overset{CH_3}{Si}}-O\right]_{18}-\underset{CH_3}{\overset{CH_3}{Si}}-H \quad (9)$$

Component (C): 5% chloroplatinic acid 2-ethylhexanol solution as an addition reaction catalyst
Component (D): flat boron nitride HSPD50 (aspect ratio 75:1, average particle size 50 μm, manufactured by Dandong Chemical Engineering Institute Co.)
Component (E): toluene as a diluting solvent during kneading

The above components (A) to (D) and component (E) were added in the specified amounts shown in Examples 1 to 5 and Comparative Examples 1 to 9 in Table 1 below, and kneaded in a planetary mixer for 60 minutes to obtain a thermally conductive silicone composition.

(Producing insulating and thermally conductive sheet)

The molds used in the examples and comparative examples are described below with reference to the drawings.

(Filling step)

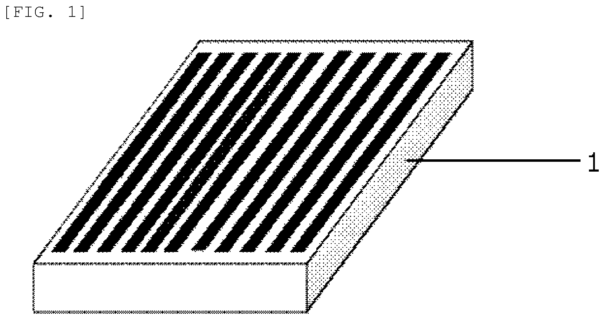

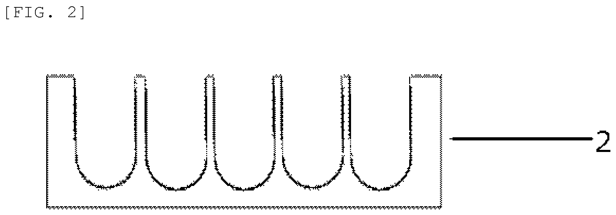

FIG. 1 is a mold 1 used in the filling step of the present invention. FIG. 2 is a cross-section of a mold 2 used in the filling step. A mold used for the filling step and having a groove with a width of 1.5 mm, a length of 50.0 mm, and a depth of 2.5 mm, with a semicircular bottom; a lower mold used for the molding step and having internal dimensions of a width of 33.0 mm (X-axis), a length of 52.0 mm (Y-axis), and a depth of 50.0 mm (Z-axis); and an upper mold used for the molding step and having internal dimensions of a width of 32.9 mm, a length of 51.9 mm, and a height of 40.0 mm were prepared. The thermally conductive silicone resin composition prepared by the above method was filled such that it overflowed from the groove, and the overflowing portion was scraped off with a squeegee.

(Vibration step)

The mold filled with the thermally conductive silicone composition was vibrated for 30 minutes using a UT-106 tabletop ultrasonic cleaner, manufactured by Sharp Corporation at a water temperature of 25°C, a frequency of 37 kHz, and 100% output, and was then dried for 2 minutes in an 80°C environment to obtain a string-like semi-cured silicone composition.

(Molding step)

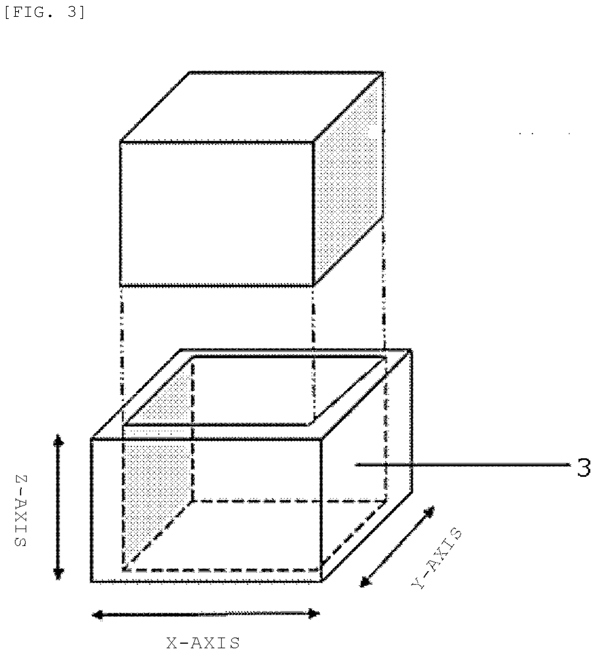

FIG. 3 is a mold 3 used in the molding step. The string-like semi-cured silicone composition was filled into the bottom of the mold shown in FIG. 3, aligned in the Y-axis direction, forming 21 rows in the X-axis direction and 40 columns in the Z-axis direction, and was then heated at 120°C for 30 minutes while being pressurized in the Z-axis direction at 1.0 MPa using a hydraulic press to obtain a molded body.

(Slicing step)

The molded body was sliced parallel to the X-Z plane with a utility knife to obtain an insulating and thermally conductive sheet.

(Evaluation of insulating and thermally conductive sheet)

The insulating and thermally conductive sheets obtained in Examples 1 to 5 and Comparative Examples 1 to 8 were evaluated as follows.

In addition, in Comparative Example 9, the above vibration step and molding step were not performed, and the sheet was poured directly into a 60 mm × 60 mm × 2 mm mold, pressurized at 1.0 MPa with a hydraulic press, and heated at 120°C for 10 minutes to fabricate a molded body, which was then evaluated in the same manner.

These results are shown in Table 1.

(Orientation degree)

An insulating and thermally conductive sheet sliced in a 2 mm thickness was punched into a 12.7 mm diameter circle, and this was used as a test piece and subjected to the measurement using a D2 PHASER 2nd Generation benchtop powder X-ray diffractometer, manufactured by Bruker Japan K.K., under the following conditions: scan range: 20 to 90°, step size: 0.024°, sample rotation: 10 rpm, voltage: 30 kV, and current: 10 mA, and the sum of the counts for $2\theta$ = 41 to 43° (100 plane) and 25 to 27°

(002 plane) was calculated.

The orientation degree was defined by the following formula.

Orientation degree = sum of counts for [$2\theta$ = 41 to 43°] / sum of counts for [$2\theta$ = 25 to 27°]

(Thermal conductivity)

The insulating and thermally conductive sheet sliced in a 2 mm thickness was punched out into a 12.7 mm diameter circle, and this was used as a test piece and the thermal conductivity was measured in accordance with JIS R 1611:2010 using the laser flash method (LFA 447 Nanoflash, manufactured by NETZSCH-Gerätebau GmbH).

(Hardness)

The hardness of the insulating and thermally conductive sheet sliced in a 12 mm thickness was measured at 25°C using a Shore A hardness tester.

(Breakdown voltage)

The insulating and thermally conductive sheet sliced in a 1 mm thickness was immersed in oil, and the breakdown voltage was measured according to JIS C 2110-1:2016.

(Specific gravity)

The specific gravity of the insulating and thermally conductive sheet sliced in a 2 mm thickness was measured at 25°C using an automatic specific gravity measuring device (SGM-6, manufactured by METTLER TOLEDO) in accordance with JIS K 6249:2003, using the water displacement method.

(Compression test)

The insulating and thermally conductive sheet sliced in a 1 mm thickness was pressed against the flat surface with a 15 mm diameter cylindrical compression pin attached to a precision autograph (AG-Xplus, manufactured by Shimadzu Corporation) at a rate of 0.5 mm/min until a maximum stress of 1.0 MPa was reached, and then the pressure was maintained for 5 minutes. Thereafter, the pressure was released, and the insulating and thermally conductive sheet was visually inspected for chips or cracks.

[Table 1]

| | Exampl e 1 | Example 2 | Exampl e 3 | Example 4 | Example 5 | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|---|---|---|---|---|
| A1 | 88.9 | 88.9 | 88.9 | 88.9 | 88.9 | 88.9 | 88.9 | 88.9 | 88.9 | 88.9 | 88.9 | 88.9 | 88.9 | 88.9 |
| A2 | 11.1 | 11.1 | 11.1 | 11.1 | 11.1 | 11.1 | 11.1 | 11.1 | 11.1 | 11.1 | 11.1 | 11.1 | 11.1 | 11.1 |
| B1-a | 1.3 | 1.9 | 1.1 | 0.0 | 0.7 | 3.8 | 0 | 0 | 1.0 | 1.0 | 1.8 | 1.3 | 1.3 | 1.3 |
| B1-b | 0 | 0 | 0 | 1.13 | 0 | 0 | 0 | 0 | 0 | 0 | 0 | 0 | 0 | 0 |
| B1-c | 0 | 0 | 0 | 0 | 0 | 0 | 0 | 15.0 | 0 | 0 | 0 | 0 | 0 | 0 |
| B2-d | 50.3 | 37.7 | 53.9 | 45.4 | 0 | 0 | 75.7 | 24.0 | 0 | 40.3 | 70.2 | 50.3 | 50.3 | 50.3 |
| B2-e | 0 | 0 | 0 | 0 | 20.1 | 0 | 0 | 0 | 0 | 0 | 0 | 0 | 0 | 0 |
| B2-f | 0 | 0 | 0 | 0 | 0 | 0 | 0 | 0 | 10.3 | 0 | 0 | 0 | 0 | 0 |
| C | 1.0 | 1.0 | 1.0 | 1.0 | 1.0 | 1.0 | 1.0 | 1.0 | 1.0 | 1.0 | 1.0 | 1.0 | 1.0 | 1.0 |
| D | 525 | 525 | 525 | 525 | 525 | 525 | 525 | 525 | 525 | 525 | 525 | 1000 | 180 | 525 |
| Total of parts by mass of component A | 100 | 100 | 100 | 100 | 100 | 100 | 100 | 100 | 100 | 100 | 100 | 100 | 100 | 100 |
| Molar ratio of component B hydrosilyl group to component A alkenyl group | 1.5 | 1.5 | 1.5 | 1.5 | 1.4 | 1.5 | 1.5 | 1.5 | 1.4 | 1.2 | 2.1 | 1.5 | 1.5 | 1.5 |
| Ratio of a ramber of moles of hydrosilyl groups between component (BI) and component (B2) | 1:2.1 | 1:1 | 1:2.6 | 1:1.4 | 1:3.8 | 1:0 | 0:1 | 1:0.5 | 1:2.7 | 1:2.1 | 1:2.0 | 1:2.1 | 1:2.1 | 1:2.1 |
| Oriertation degree | 3.2 | 3.6 | 2.8 | 2.4 | 3.2 | 4.1 | 2.6 | 3.2 | 3.9 | 3.0 | 2.9 | 5.9 | 1.6 | 0.1 |
| Thermal conductivity (W/mk) | 25.1 | 25.2 | 24.8 | 24.9 | 25.6 | 26.2 | 24.3 | 26.6 | 25.6 | 18.6 | 21.3 | 31.9 | 14.7 | 7.4 |

(continued)

| | Exampl e 1 | Example 2 | Exampl e 3 | Example 4 | Example 5 | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|---|---|---|---|---|
| Shore A hard-ness | 20 | 33 | 17 | 36 | 26 | 38 | 15 | 12 | 26 | 2 | 0 | 66 | 3 | 20 |
| Breakdown voltage (kV/mm) | 10 | 10 | 10 | 10 | 10 | 10 | 10 | 10 | 10 | 10 | 10 | 12 | 8 | 12 |
| Specific gravity | 1.5 | 1.5 | 1.5 | 1.5 | 1.5 | 1.5 | 1.5 | 1.5 | 1.5 | 1.5 | 1.5 | 1.6 | 1.4 | 1.5 |
| Presence or absence of cracks or clips after compres-sion test | Absence | Absence | Absence | Absence | Absence | Cracks | Cracks | Cracks | Cracks | Cracks | Cracks | Cracks | Cracks | Absence |

Comparing Examples 1 to 4 with Comparative Examples 1 to 3, and Example 5 with Comparative Example 4, although the molar ratio of hydrosilyl groups in the component B to alkenyl groups in the component A was the same, Examples 1 to 3 and 4, which included appropriate amounts of the components (B1) and (B2), showed no cracks or chips after the compression test, whereas Comparative Examples 1 to 3 and 4, which did not include both components appropriately, showed cracks after the compression test. These results demonstrated that the insulating and thermally conductive sheet with excellent mechanical strength can be obtained by using the appropriate blend of the components B1 and B2.

Meanwhile, as in Comparative Examples 5 and 6, it was demonstrated that when the molar ratio of hydrosilyl groups in the component B to alkenyl groups in the component A is not appropriate, the insulating and thermally conductive sheet with sufficient hardness cannot be obtained, raising concerns that the insulating and thermally conductive sheet may be damaged during use.

Further, the results of Comparative Examples 7 and 8 showed that the strength and thermal conductivity of the insulating and thermally conductive sheet are also affected by the content of the flat boron nitride (component (D)).

In addition, the results of Example 1 and Comparative Example 9 showed that when the orientation degree is less than 1, thermal conduction paths parallel to the thickness direction of the sheet are not formed, and sufficient thermal conductivity cannot be obtained through the thickness direction.

As described above, the present invention can provide the insulating and thermally conductive sheet that exhibits excellent thermal conductivity in the thickness direction while also having high sheet strength.

The present invention is not limited to the above-described embodiments. The above-described embodiments are illustrative, and any other material that has substantially the same configuration as the technical concept described in the claims of the present invention and exhibits similar effects is within the technical scope of the present invention.

## Claims

**1.** An insulating and thermally conductive sheet, being a cured product of a thermally conductive silicone resin composition comprising following components (A) to (D), wherein
a peak intensity ratio (degree of orientation) in a thickness direction as detected by X-ray diffraction method of the insulating and thermally conductive sheet is [2θ = 41 to 43°]/[2θ = 25 to 27°] = 1 or more:

(A) an organopolysiloxane having two or more alkenyl groups bonded to a silicon atom per molecule: 100 parts by mass;

(B) an organohydrogenpolysiloxane containing the following components (B1) and (B2), and having two or more hydrosilyl groups per molecule: an amount of the component (B) added is such that a number of moles of hydrosilyl groups derived from the component (B) is 1.3 to 2.0 based on 1 mole of alkenyl groups derived from the component (A), and a ratio of a number of moles of hydrosilyl groups in the component (B1) to the component (B2) is 1:1 to 1:5 :

(B1) an organohydrogenpolysiloxane represented by the following formula (1):

$$CH_3-\overset{\displaystyle CH_3}{\underset{\displaystyle CH_3}{Si}}-O-\left[\overset{\displaystyle H}{\underset{\displaystyle CH_3}{Si}}-O\right]_m-\left[\overset{\displaystyle CH_3}{\underset{\displaystyle CH_3}{Si}}-O\right]_n-\overset{\displaystyle CH_3}{\underset{\displaystyle CH_3}{Si}}-CH_3 \quad (1)$$

wherein "m" is an integer of 4 to 20, "n" is an integer of 10 to 40, and the sequence of bonding of siloxane units enclosed by "m" and "n" can be structured in either a block or random fashion,

(B2) an organohydrogenpolysiloxane having hydrosilyl groups only at both ends, represented by the following formula (2):

$$H-\overset{\displaystyle CH_3}{\underset{\displaystyle CH_3}{Si}}-O-\left[\overset{\displaystyle CH_3}{\underset{\displaystyle CH_3}{Si}}-O\right]_p-\overset{\displaystyle CH_3}{\underset{\displaystyle CH_3}{Si}}-H \quad (2)$$

wherein "p" is an integer of 40 to 200;

(C) a hydrosilylation catalyst: an amount that provides 100 to 3,000 ppm of platinum group metal elements on a mass basis based on the component (A); and

(D) a flat boron nitride having an average particle size of 30 to 100 μm as measured by laser diffraction and having an aspect ratio of 20 to 100: 200 to 800 parts by mass.

**2.** The insulating and thermally conductive sheet according to claim 1, wherein a thermal conductivity in a thickness direction of the insulating and thermally conductive sheet is 17 to 30 W/m·K.

**3.** The insulating and thermally conductive sheet according to claim 1, wherein a Shore A hardness of the insulating and thermally conductive sheet is 5 to 60.

**4.** The insulating and thermally conductive sheet according to claim 1, wherein a breakdown voltage of the insulating and thermally conductive sheet is 5 kV/mm or more.

**5.** The insulating and thermally conductive sheet according to claim 1, wherein a specific gravity of the insulating and thermally conductive sheet is 1.2 to 2.0.

[FIG. 1]

1

[FIG. 2]

2

[FIG. 3]

3
Z-AXIS
Y-AXIS
X-AXIS

## INTERNATIONAL SEARCH REPORT

International application No.
**PCT/JP2024/032707**

**A. CLASSIFICATION OF SUBJECT MATTER**

***H01L 23/36***(2006.01)i; ***C08J 5/18***(2006.01)i; ***C08L 83/05***(2006.01)i; ***C08L 83/07***(2006.01)i; ***H01L 23/373***(2006.01)i; ***H05K 7/20***(2006.01)i
FI: H01L23/36 D; C08L83/07; C08L83/05; H05K7/20 D; H01L23/36 M; C08J5/18 CFH

According to International Patent Classification (IPC) or to both national classification and IPC

**B. FIELDS SEARCHED**

Minimum documentation searched (classification system followed by classification symbols)

H01L23/36; C08J5/18; C08L83/05; C08L83/07; H01L23/373; H05K7/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2017/034003 A1 (DENKA CO., LTD.) 02 March 2017 (2017-03-02) entire text, all drawings | 1-5 |
| A | WO 2016/208458 A1 (SEKISUI POLYMATECH CO., LTD.) 29 December 2016 (2016-12-29) entire text, all drawings | 1-5 |
| A | JP 2012-59811 A (MOCHIDA SHOKO KK) 22 March 2012 (2012-03-22) entire text, all drawings | 1-5 |
| A | JP 6-155517 A (SHIN-ETSU CHEMICAL CO., LTD.) 03 June 1994 (1994-06-03) entire text, all drawings | 1-5 |

☐ Further documents are listed in the continuation of Box C.   ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 October 2024** | **29 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/032707**

| Patent document cited in search report | Publication date (day/month/year) | Patent family member(s) | Publication date (day/month/year) |
|---|---|---|---|
| WO 2017/034003 A1 | 02 March 2017 | US 2018/0230352 A1 | |
| | | CN 107922743 A | |
| | | KR 10-2018-0048612 A | |
| WO 2016/208458 A1 | 29 December 2016 | US 2018/0292148 A1 | |
| | | CN 107851623 A | |
| JP 2012-59811 A | 22 March 2012 | (Family: none) | |
| JP 6-155517 A | 03 June 1994 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012023335 A
- JP 2019186555 A
- JP 2017126614 A
- WO 2021090929 A1
- US 3220972 A
- US 3159601 A
- US 3159662 A
- US 3775452 A